# EUROPEAN PATENT APPLICATION

(11) **EP 0 984 328 A2**
(43) Date of publication of application: **08.03.2000**
(21) Application number: 99117300.6
(22) Date of filing: 02.09.1999
(51) Int. Cl.: G03F 7/00

(54) **A method of surface etching silica glass, for instance for fabricating phase masks**

(30) Priority: 04.09.1998 IT TO980747
(71) Applicant: CSELT Centro Studi e Laboratori Telecomunicazioni S.p.A., 10148 Turin (IT)
(72) Inventor: Ardito, Marco, 10146 Torino (IT); Meneghini, Giancarlo, 10141 Torino (IT)
(74) Representative: Riederer Freiherr von Paar zu Schönau, Anton

(57) **Abstract**

A layer of electrically conductive material (2) is deposited. on a silica glass substrate (1) with a surface to be etched. A pattern (4) reproducing the etching pattern to be fabricated on the substrate surface is formed on such conductive material (2) through deposition, exposure and development of a resist (3), by leaving uncovered the areas of said conductive material layer (2) corresponding to the areas of the substrate (1) to be etched. As a conductive material, a material such as titanium is chosen, which can be etched by the same etching medium, such as CHF₃, used for etching the substrate (1). The removal of said conductive material layer (2) and the etching of the substrate (1) in the areas left uncovered by the resist are then performed in a single step .

## Description

This invention concerns surface etching of silica glass (quartz) and has been developed in particular in view of its possible application to the fabrication of phase masks to be used for instance for fabricating Bragg gratings in optical fibres for telecommunications.

The use of phase masks for fabricating gratings in an optical fibre is an established technique. For a general description of such a technique reference may be made to the paper by K. O. Hill, B. Malo, F Bilodeau, D. C. Johnson and J. Albert, "Bragg gratings fabricated in a monomode photosensitive optical fibre by UV exposure through a phase mask", Applied Physics Letters, Vol. 62, No 10, pages 1035 to 1037, 1993.

In the essence, the phase masks are formed by a grating etched on one of the faces of a substrate of silica glass transparent to UV radiation. The depth of the grooves and the profile of the grating etched into the mask are accurately optimised as a function of the characteristics of the grating to be fabricated in the fibre. To perform the writing of the grating in the fibre core, an UV laser beam orthogonally illuminates the mask. The opposite surface, on which the grating is reproduced and which is leant against the fibre, causes the diffraction of the light beam into a series of orders of different intensity. By optimising the fabrication of a grating, it is possible to cut down the null order diffraction to below 5 percent, whereas both orders +1 and -1 contain about 40 percent of diffracted light.

In general terms, the fabrication of phase masks carried out according to the known technique recalled in the preamble to claim 1, envisages the deposition of a resist layer on the substrate to be etched, on which a conductive material layer, usually metallic chromium, has been previously deposited. Then, through a holographic technique or electron beam lithography (EBL), a grating pattern is fabricated in the resist. Thereafter, the actual etching operations are performed in order to transfer the resist pattern into the substrate.

Etching is usually performed according to a positive plasma etching technology called RIE (Reactive Ion Etching). For the description of the known technique reference may be made to the paper "Fabrication of phase mask with sub-half micron resolution by electron beam lithography" by E. Di Fabrizio et al., Microelectronics Engineering 41/42 (1998), page 121.

The deposition of a conductive layer on the substrate is designed to prevent surface charge effects, in particular those caused by the electron beam used in the EBL technique, and to increase the etching resistance of the resist mask.

The accuracy of the final result depends on two factors, namely the accuracy of the etching of the conductive material after resist development, and the accuracy of the etching of the underlying substrate after etching the conductive layer. More particularly, it has been proved that etching of the silica glass can undesirably occur even in areas usually protected by the resist and the underlying conductive layer. For the same reason, any inaccuracy in the etching of the conductive layer can be amplified when etching the silica glass substrate.

This invention aims at providing a method for the surface etching of silica glass wherein the above drawbacks are overcome.

According to this invention, this aim is attained by means of a method having the characteristics specifically mentioned in the claims hereinafter.

In short, the solution according to the invention envisages that the etching of the conductive layer and silica glass substrate is carried out in one step only, thus cutting down fabrication time, reducing process complexity as well as increasing its accuracy.

The invention is therefore based on a joint choice of the characteristics of the conductive layer and the medium used for the etching phase. In particular, in its preferred embodiment, the metallic chromium, which is conventionally used for the creation of the conductive layer, is replaced by titanium. As a matter of fact, the latter can be dry-etched by a gas such as CHF₃ that can be used in a totally satisfactory way also for etching the silica glass substrate.

The invention will now be described by way of a non-limiting example, with reference to the attached drawings, where:
- Figures 1 to 8 represent subsequent phases of an exemplary embodiment of the method according to the invention, and
- Figure 9 is an interferogram of the etching of a phase mask implemented according to the invention.

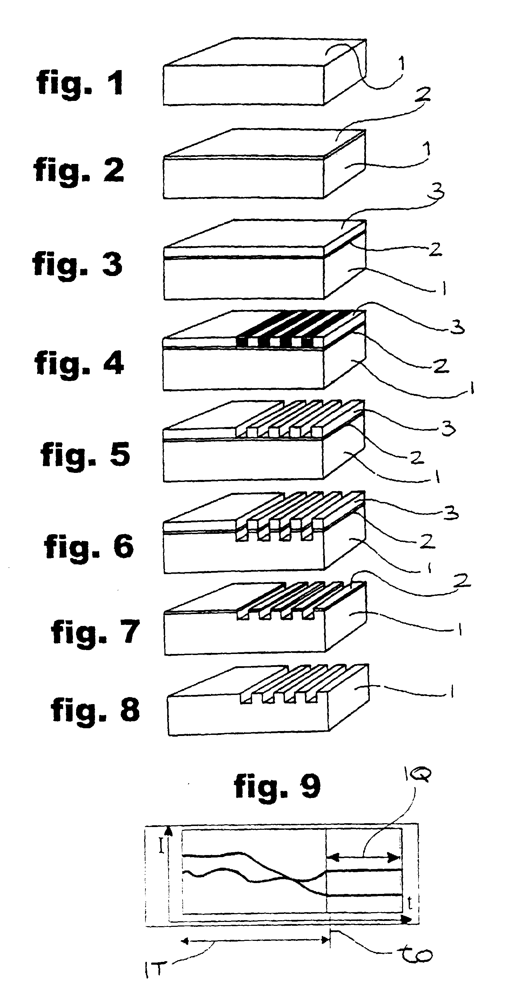

The first step of the method according to the invention, depicted in Figure 1, concerns the preparatory treatment of substrate 1 to be etched. It may be a silica glass (quartz) substrate transparent to UV light, to be used for the fabrication of a phase mask. Such a mask may in turn be used (through a known technique, not described here in detail being not of interest for the understanding of the invention) to fabricate Bragg gratings in optical fibres. For the envisaged application (fabrication of phase masks) it is important that the mask itself has a high surface finishing, and for this reason substrates characterised by a high degree of surface finishing, such as 1/4 lapping, are preferably used.

To avoid the surface charge effects, a thin layer 2 of conductive material, preferably titanium, is deposited on substrate 1. The deposition is obtained though vapour deposition of 10-20 nm (100-200 Å) titanium.

The choice of titanium (instead of metallic chromium, conventionally used for this purpose) is at the moment a preferential choice, though absolutely not essential for the application of the invention. Alternative choices that are considered at the moment as less preferred, are represented for instance by tungsten, molybdenum or tantalum. However, the invention is applicable with any conductive material which may be deposited in a thin layer on substrate 1 and etched by a means (usually a gas) capable of performing an etching on substrate 1.

A uniform resist layer 3 is created on conductive layer 2 through deposition (Figure 3) and then submitted to a heat treatment specific for the resist adopted. The choice of the resist type and its treatment are not limiting for this invention. It is however important that the resist preferably has the following characteristics:
- an adequate resolution (for instance less than 0.5 µm),
- an adequate thickness (for instance, greater than or equal to 0.4 µm);
- a good resistance to dry etching by CHF₃, and ease of removal.

In an embodiment of the invention, use has been made of a commercial resist, having the trade name Shipley UV III, which is a positive resist designed for UV optical lithography, and is also sensitive to electrons, thus applicable with excellent results also to the EBL technique. The treatment specifications for this resist are reported on the manufacturer's data sheet and therefore it is not necessary to recall them herein.

Subsequently, as has been schematised in Figure 4, the exposure according to the EBL technique is performed, also in this case in known manner. The EBL technique is at the moment preferred to the holographic technique, since it allows more freedom in choosing the type of grating to be fabricated (possibility of "custom grating" manufacturing). Nevertheless this invention is also applicable to gratings manufactured through holography. In an exemplary embodiment of the method performed by means of the EBL technique, use has been made of an equipment with the trade name LeicaVB5HR, for writing 15 mm long and 3 mm wide gratings.

The subsequent development phase depicted in Figure 5 is aimed at removing the exposed resist (a positive resist, in the given example). Said operation is to uncover the areas to be etched and it is carried out for a time sufficient to an accurate cleaning of the profile edges.

Then the etching phase of the areas left uncovered by the resist is carried out, as schematised in Figure 6. According to an important feature of the invention, etching is performed in such a way as to transfer the pattern first through the conductive layer 2 and then into substrate 1, while keeping the correct proportions for the requested etching profile and accurately setting the etch depth according to the required value.

In the embodiment of the invention being preferred at the moment, etching is effected through a single phase RIE (i.e. Reactive Ion Etching) technique i.e. in a single etching for layer 2 of titanium and for substrate 1 of silica glass (quartz), using CHF₃ gas as a dry etching medium. In particular, different conditions have been evaluated for the RIE etching, such as type, pressure, process gas flows and power of the plasma discharge. The choice described here has proven highly preferential with respect to other fluorocarbons, such as CF₄, which has a mainly chemical etching mechanism, as well as to argon, which has a mainly physical etching mechanism. This choice has been dictated by characteristics relating to both the reduced selectivity with the resist and the high surface roughness that is obtained using those gases. An alternative to the use of CHF₃ is offered by the use of sulphur fluorides, such as, for instance, SF₄.

As for the use of CHF₃, the following conditions have been so far preferred:
- etching performed by constant bias, equal to about -600 V (power varies around approximately 300-350 W);
- pressure of about 10.5 Pa (80 mTorr) and
- flows of about 40 sccm (standard cubic centimetres per minute).

Etching by CHF₃ appears to be particularly sensitive to the cleanness and conditioning conditions of the reactor. Furthermore, during the etching operations, material of complex composition originating from the reaction products is deposited on the reactor walls, modifying their characteristics and causing thereby fluctuations in the plasma, and hence etching conditions. In order to reduce the unwanted effects, the first condition cited above must be regarded as particularly important, since it allows a uniform and reproducible etching, regardless of the reactor operating conditions. For the pressure and flows, appropriate values lie within an interval substantially set around the preferred value, in particular about 7 to 12 Pa (70-90 mTorr) and 35-45 sccm, respectively.

When these conditions are matched, roughness of the etched surfaces becomes minimal, etching rate is about 70-75 nm/min (700-750 Å/min), and a full reproducibility is assured.

The etching phase of conductive layer 2 of titanium and of substrate 1 is preferably monitored by measuring the surface reflectivity, during etching, by means of an instrument called "end point detector" (EPD), of the type described for instance in the paper "High-resolution depth monitoring of reactive ion etching for In/InGaAs (P) WQW using reflectance measurements" by A. Stano, C. Coriasso, G. Meneghini, Semiconductor Science and Technology, 11 (1996), pages 968 to 973. This instrument allows monitoring the effective etching time of quartz, regardless of the thickness of the deposited titanium layer (which may vary during different depositions).

As illustrated in Figure 9, the typical interferogram obtained during the etching phase allows clearly detecting the instant t0 in which the titanium etching ends (interval IT) and the quartz etching (interval IQ) begins. According to calibrations carried out at a rate of the order of that previously indicated, i.e. 75 nm/min, additional 195 seconds are usually required to obtain an etching depth of the mask of the order of 245 nm.

Figures 7 and 8 show the final phases of the mask fabrication, which practically correspond to the cleaning of the same. The experiments conducted by the Applicant have found out that this phase is important to attain a good final result, in order that both the surface left uncovered by the resist and submitted to etching, and the surface protected during the etching of the titanium and resist layers, be free of residue of previously existing layers. The inaccuracy in the grating has a great impact on the phase mask performance.

The resist layer can be removed as shown in Figure 7 by using for instance an O₂ plasma, with a power of about 300 W for ten minutes. As an alternative it is generally sufficient to effect a cleaning by means of hot acetone for a same time. These operations are absolutely conventional.

The complete removal of the residual titanium (Figure 8) can be performed, for instance, through a water solution of ethilenediamine tetraacetic acid (EDTA), NH₄OH and H₂O₂ in an ultrasonic bath for about ten minutes. Dipping the mask into a particularly aggressive solution, for instance H₂SO₄ and H₂O₂ (in a 4:1 ratio), again in an ultrasonic bath for about ten minutes, usually completes the cleaning operation.

Inspection through a scanning electron microscope (SEM) of masks made according to the method of the invention has demonstrated the possibility of attaining very good profiles, i.e. practically vertical profiles, with an extremely smooth ground of the grooves. Analysis through an atomic force microscope (AFM) of the roughness in the etched part and in the areas protected by the resist does not show any difference.

It is evident that, while keeping unchanged the invention principle set forth herein, the implementation details and the embodiments can be varied considerably with regard to what has been described and illustrated, without departing from the scope of this invention, as will defined in the following claims.

## Claims

1. Method of surface etching silica glass, comprising the operations of:
- providing a substrate (1) of silica glass with a surface to be etched;
- depositing on said surface a layer (2) of electrically conductive material,
- fabricating on said layer of conductive material (2), through deposition, exposure and development of a resist (3), a pattern representative of the etching pattern to be implemented on the substrate surface (1), by making uncovered the areas of said conductive layer (2) corresponding to the areas to be etched,
- removing said conductive layer (2) from the areas made uncovered,
- etching said substrate (1) in the areas made uncovered by means of an etching medium,
- removing the residue of said resist layer and of said conductive layer,
characterised in that the method further comprises the operations of:
- choosing as the conductive material, a material that can be etched by said etching medium, and
- carrying out, in a single step, through said etching medium, the removal of said layer (2) of conductive material and the etching of said substrate (1) in said areas that were made uncovered.

2. Method according to claim 1, characterised in that said conductive material is chosen out of the group formed by titanium, tungsten, molybdenum and tantalum.

3. Method according to claim 2, characterised in that said conductive material is titanium.

4. Method according to any of claims 1 to 3, characterised in that said etching medium is a chemical etching medium.

5. Method according to any of the previous claims, characterised in that said etching medium is a gas activated in a plasma discharge.

6. Method according to any of the previous claims, characterised in that said etching medium is a fluorine compound, selected from the group formed by fluorocarbons and sulphur fluorides.

7. Method according to claim 6, characterised in that said etching medium is CHF₃.

8. Method according to claim 7, characterised in that said etching medium is kept at a pressure between about 9 Pa (70 mTorr) and about 12 Pa (90 mTorr).

9. Method according to claim 7 or 8, characterised in that said etching medium is supplied with a flow between about 35 sccm and about 40 sccm.

10. Method according to any of claims 7, 8 and 9, characterised in that said etching medium is activated through a constant bias voltage.

11. Method according to claim 10, characterised in that said bias voltage is of about -600 V, with a power of about 300-350 W.

12. Method according to any of the previous claims, characterised in that the residue of said layer (2) of conductive material is removed through a water solution of ethilenediamine tetraacetic acid, NH₄OH and H₂O₂ in an ultrasonic bath.

13. Method according to any of claims 1 to 12, characterised in that said residue of said conductive material layer (2) is removed by dipping said etched substrate into a solution of H₂SO₄ and H₂O₂.
